# EUROPÄISCHE PATENTSCHRIFT

(11) **EP 0 816 172 B1**
(45) Veröffentlichungstag und Bekanntmachung des Hinweises auf die Patenterteilung: **27.08.2003**
(21) Anmeldenummer: 97110441.9
(22) Anmeldetag: 26.06.1997
(51) Int. Cl.: B60R 11/02

(54) **Elektrisches Gerät, insbesondere CD-Wechsler, zum Anschluss an ein zweites elektrisches Gerät, insbesondere ein Autoradio**
Electrical apparatus,in particular a CD changer,for connection to a second electrical apparatus in particular an autoradio
Appareil électrique, en particulier changeur CD, à raccorder à un deuxième appareil électrique, en particulier in autoradio

(30) Priorität: 06.07.1996 DE 19627384
(43) Veröffentlichungstag der Anmeldung: 07.01.1998
(73) Patentinhaber: ROBERT BOSCH GMBH, 70442 Stuttgart (DE)
(72) Erfinder: Wöhl, Wilhelm, 31135 Hildesheim (DE)

(56) Entgegenhaltungen:
- EP-A- 0 636 516
- DE-A- 3 717 054
- DE-A- 3 723 931

## Beschreibung

### Stand der Technik

Die Erfindung geht von einem elektrischen Gerät nach der Gattung des Hauptanspruchs aus, wie es dem Patentanmelder bekannt ist.

Aus der Bedienungsanleitung des Blaupunkt Autoradios ACM 5450 ist bereits ein Autoradio bekannt, bei dem die Unterbrechung der Betriebsspannung die Aktivierung eines Diebstahlschutzes bedingt.

### Vorteile der Erfindung

Das erfindungsgemäße elektrische Gerät mit den Merkmalen des Hauptanspruchs hat demgegenüber den Vorteil, daß mit wenig Aufwand in einer definierten Zeit und Weise schnell und sicher eine Code-Aktivierung nach Spannungsunterbrechung noch während der Demontage des elektrischen Gerätes sichergestellt ist.

Durch die in den Unteransprüchen aufgeführten Maßnahmen sind vorteilhafte Weiterbildungen und Verbesserunger des im Hauptanspruch angegebenen elektrischen Gerätes möglich.

Vorteilhaft nach Anspruch 2 ist die Ausnutzung der ohnehin im ersten elektrischen Gerät verbleibenden Restladung eines Kondensators. Auf diese Weise ist kein wesentlicher Zusatzaufwand zur Einstellung der Spannungsdifferenz erforderlich.

Vorteilhaft gemäß Anspruch 3 ist die Verwendung eines Spannungsteilers, einer Diode und eines Schalters zur definierten Auslösung des Sicherungsvorgangs in der Kontrolleinheit. Auf diese Weise wird eine einfache und wenig aufwendige Sicherungsschaltung realisiert, die zudem besonders preiswert ist.

Vorteilhaft nach Anspruch 4 ist die Schaltung eines zweiten Kondensators zwischen dem Steuereingang des Schalters und dem ersten Bezugspotential, wobei die Kapazität des zweiten Kondensators kleiner als die Kapazität des ersten Kondensators ist. Auf diese Weise wird das Durchschalten des Schalters und damit die Aktivierung des Sicherungsvorgangs in der Kontrolleinheit bei kurzzeitigen Spannungsunterbrechungen, induktiven Störungen oder Pegelspitzen verhindert, so daß der Sicherungsvorgang in der Kontrolleinheit möglichst nur bei Spannungsunterbrechung durch Diebstahl aktiviert wird.

Vorteilhaft nach Anspruch 5 ist die Versorgung der Kontrolleinheit nach Spannungsunterbrechung durch die Restladung des ersten Kondensators. Auf diese Weise wird die Kontrolleinheit auch nach Spannungsunterbrechung durch Diebstahl noch mit Energie versorgt, so daß der Sicherungsvorgang aktiviert werden kann.

Vorteilhaft nach Anspruch 8 ist die Aktivierung des Sicherungsvorgangs nach einer durch einen mit der Kontrolleinheit zusammenwirkenden Timer vorgebbaren Verzögerungszeit. Auf diese Weise wird ebenfalls verhindert, daß eine auf Störungen zurückzuführende kurzzeitige Spannungsunterbrechung zur Aktivierung des Sicherungsvorgangs in der Kontrolleinheit führt.

Vorteilhaft nach Anspruch 9 ist die Möglichkeit, das elektronische Schloß durch Eingabe eines Codewortes an einem mit der Kontrolleinheit verbundenen Bedienteil des ersten elektrischen Gerätes zu entriegeln. Auf diese Weise kann der Benutzer für den Fall, daß eine möglicherweise ungewollte Spannungsunterbrechung zur Aktivierung des Sicherungsvorgangs in der Kontrolleinheit führte, den Funktionszustand des elektrischen Gerätes auf einfache Weise wiederherstellen, wenn die Spannungsversorgung wiederhergestellt ist.

Vorteilhaft nach Anspruch 10 ist die Messung der Versorgungsspannung oder einer daraus abgeleiteten Größe im ersten elektrischen Gerät, die Zuführung des Meßergebnisses zu der Kontrolleinheit und die Zusatzbedingung für die Aktivierung des Sicherungsvorgangs in der Kontrolleinheit, daß die gemessene Versorgungsspannung oder die daraus abgeleitete Größe im ersten elektrischen Gerät unter einen vorgegebenen Wert absinken muß. Auf diese Weise wird der Schutz der Sicherungsschaltung vor versehentlicher Aktivierung des Sicherungsvorgangs weiter verbessert.

Vorteilhaft nach Anspruch 11 ist die Möglichkeit, dem dritten Kondensator, an dem die Versorgungsspannung zumindest teilweise anliegt, einen Widerstand zur schnellen Entladung des dritten Kondensators beim Entfernen der Versorgungsspannung parallel zu schalten. Auf diese Weise wird erreicht, daß der entsprechende Teil der Versorgungsspannung schneller sinkt, als die Betriebsspannung, so daß die Kontrolleinheit nach Detektion des Absinkens des entsprechenden Teiles der Versorgungsspannung unter den vorgegebenen Wert noch genügend Zeit hat, um den Sicherungsvorgang zu aktivieren. Wenn der Widerstand nur beim Entfernen der Versorgungsspannung zugeschaltet wird, können Verlustströme bei angeschlossener Versorgungsspannung vermieden werden.

### Zeichnung

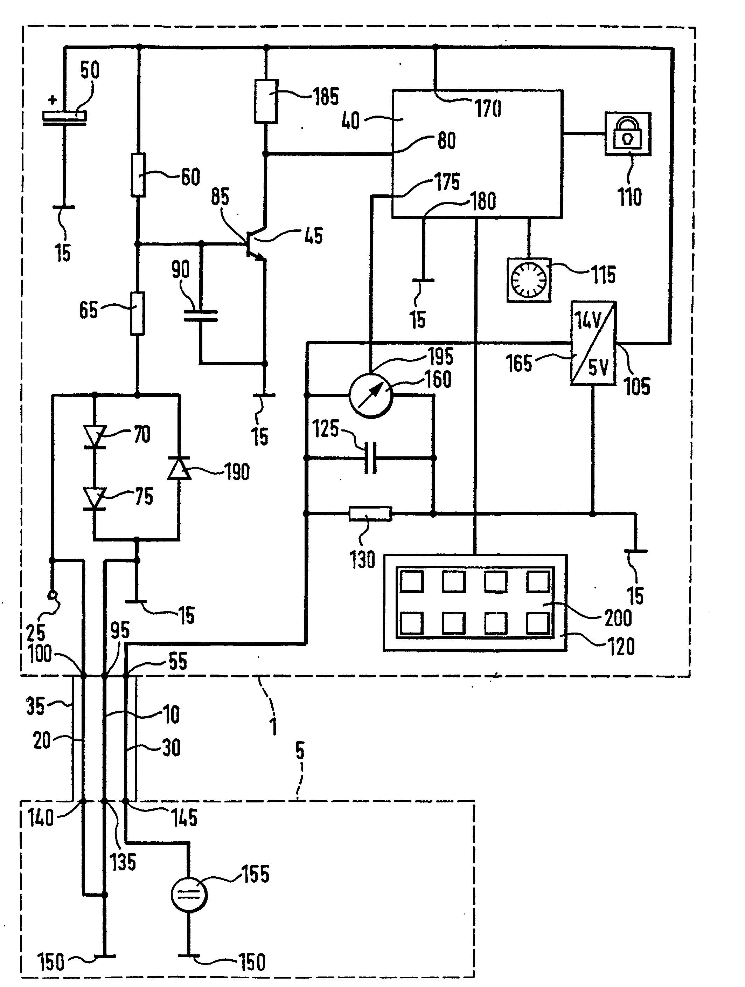

Ein Ausführungsbeispiel der Erfindung ist in der Zeichnung dargestellt und in der nachfolgenden Beschreibung näher erläutert. Es zeigt die einzige Figur ein über ein Verbindungskabel mit einem zweiten elektrischen Gerät verbundenes erstes elektrisches Gerät und den im ersten elektrischen Gerät untergebrachten Bauteilen zur Aktivierung einer Diebstahlsicherung des ersten elektrischen Gerätes.

### Beschreibung des Ausführungsbeispiels

In der Figur kennzeichnet 1 ein als CD-Wechsler ausgebildetes erstes elektrisches Gerät, das über ein Verbindungskabel 35 an ein als Autoradio ausgebildetes zweites elektrisches Gerät 5 angeschlossen ist. Die Ausbildung des ersten elektrischen Gerätes 1 als CD-Wechsler und des zweiten elektrischen Gerätes 5 als Autoradio ist dabei nur beispielhaft für die Beschreibung der Erfindung gewählt. Es können jedoch auch beliebige andere elektrische Geräte erfindungsgemäß ausgerüstet werden, beispielsweise kann das erste elektrische Gerät 1 auch ein Videorecorder oder ein Autoradio sein, die an einem als Spannungsversorgungsgerät ausgebildeten zweiten elektrischen Gerät 5 betrieben werden.

Jedenfalls weist das erfindungsgemäße erste elektrische Gerät 1 gemäß der Figur einen ersten Pol 95 für ein erstes Bezugspotential 15 für die digitale Signalverarbeitung und einen zweiten Pol 100 für ein zweites Bezugspotential 25 für die analoge Signalverarbeitung auf. Der erste Pol 95 des ersten elektrischen Gerätes 1 ist über eine erste Leitung 10, die im Verbindungskabel 35 verlegt ist, mit einem ersten Pol 135 des zweiten elektrischen Gerätes 5 verbunden und der zweite Pol 100 des ersten elektrischen Gerätes 1 ist über eine zweite Leitung 20, die ebenfalls im Verbindungskabel 35 verlegt ist, mit einem zweiten Pol 140 des zweiten elektrischen Gerätes 5 verbunden. Im zweiten elektrischen Gerät 5 sind der erste Pol 135 und der zweite Pol 140 miteinander verbunden und an ein drittes Bezugspotential 150 angeschlossen. Zwischen einem dritten Pol 145 des zweiten elektrischen Gerätes 5 und dem dritten Bezugspotential 150 ist eine Gleichspannungsquelle 155 angeschlossen. Der dritte Pol 145 des zweiten elektrischen Gerätes 5 ist über eine Versorgungsspannungsleitung 30 mit einem dritten Pol 55 des ersten elektrischen Gerätes 1 verbunden. Die Gleichspannungsquelle 155 liefert beispielsweise eine Versorgungsspannung von 14 V. Der dritte Pol 55 ist über einen Meßwiderstand 130 mit dem ersten Bezugspotential 15 verbunden. Dem Meßwiderstand 130 ist ein dritter Kondensator 125 parallel geschaltet. Dem Meßwiderstand 130 ist außerdem ein Spannungsmesser 160 parallel geschaltet. Ein Meßausgang 195 des Spannungsmessers 160 ist mit einem Spannungsmeßeingang 175 einer Kontrolleinheit 40 verbunden. An den dritten Pol 55 des ersten elektrischen Gerätes 1 ist auch ein Spannungswandler 165 angeschlossen, der die im hier gewählten Beispiel verwendete Versorgungsspannung von 14 V auf eine Betriebsspannung von 5 V wandelt und einen Betriebsspannungsausgang 105 aufweist, an dem das Betriebsspannungspotential anliegt. Der Spannungswandler 165 ist außerdem mit dem ersten Bezugspotential 15 verbunden. Der Betriebsspannungsausgang 105 des Spannungswandlers 165 ist mit einem Betriebsspannungseingang 170 der Kontrolleinheit 40 verbunden. Zwischen den Betriebsspannungsausgang 105 des Spannungswandlers 165 und das erste Bezugspotential 15 ist ein erster Kondensator 50 geschaltet, der beispielsweise als Elektrolytkondensator ausgeführt sein kann und dessen positive Elektrode mit dem Betriebsspannungsausgang 105 des Spannungswandlers 165 verbunden ist. Die Kontrolleinheit 40 ist mit einem Timer 115 und einem elektronischen Schloß 110 verbunden, wobei der Timer 115 und/oder das elektronische Schloß 110 auch in der Kontrolleinheit 40 integriert sein können. Mit der Kontrolleinheit 40 ist außerdem ein Bedienteil 120, das beispielsweise ein Tastenfeld 200 aufweisen kann, verbunden. Der Betriebsspannungsausgang 105 des Spannungswandlers 165 ist über einen ersten Spannungsteilerwiderstand 60 und einen zweiten Sannungsteilerwiderstand 65 mit der Anode einer ersten Diode 70 verbunden, deren Kathode mit der Anode einer zweiten Diode 75 verbunden ist, deren Kathode wiederum mit dem ersten Bezugspotential 15 verbunden ist. Die Kathode der zweiten Diode 75 ist außerdem mit der Anode einer dritten Diode 190 verbunden, deren Kathode mit der Anode der ersten Diode 70 verbunden ist. Die Anode der ersten Diode 70 ist außerdem mit dem zweiten Bezugspotential 25 verbunden. Zwischen dem ersten und dem zweiten Spannungsteilerwiderstand 60 und 65 ist der Steuereingang 85 eines als npn-Bipolartransistor ausgeführten gesteuerten Schalters 45 angeschlossen, dessen Emitter mit dem ersten Bezugspotential 15 und dessen Kollektor über einen Kollektorwiderstand 185 mit dem Betriebsspannungsausgang 105 des Spannungswandlers 165 verbunden ist. Anstelle des gesteuerten Schalters 45 kann auch ein anderer Sensor, wie beispielsweise ein Analog-Digital-Wandler Verwendung finden. Zwischen dem Steuereingang 85 des npn-Bipolartransistors 45 und dem ersten Bezugspotential 15 ist ein zweiter Kondensator 90 geschaltet. Der Kollektor des npn-Bipolartransistors 45 ist außerdem mit einem SAFE-Eingang 80 der Kontrolleinheit 40 verbunden. Die Kontrolleinheit 40 weist einen Bezugspotialausgang 180 auf, über den er mit dem ersten Bezugspotential 15 verbunden ist.

In den beiden elektrischen Geräten 1 und 5 sind nur die zur Funktion der Erfindung notwendigen Bauelemente dargestellt und beschrieben. Dabei faßt der erste Kondensator 50 alle mit dem Betriebsspannungsausgang 105 verbundene Kapazitäten und der dritte Kondensator 125 alle mit dem Versorgungsspannungspotential bzw. dem dritten Pol 55 des ersten elektrischen Gerätes 1 verbundenen Kapazitäten im ersten elektrischen Gerät 1 zusammen.

Die Funktionsweise der Erfindung ist wie folgt: Aufgrund der Potentialgleichheit des ersten und des zweiten Poles 95 und 100 des ersten elektrischen Gerätes 1 fällt an der ersten und der zweiten Diode 70 und 75 keine Spannung ab, so daß die beiden Dioden sperren. Bei Wahl eines relativ kleinen zweiten Spannungsteilerwiderstandes 65 von beispielsweise 1kΩ im Vergleich zu einem relativ großen ersten Spannungsteilerwiderstend 60 von beispielsweise 47 kΩ reicht bei einer Betriebsspannung von 5 V die Steuerspannung des npn-Bipolartransistors 45 nicht zum Durchschalten des npn-Bipolartransistors 45 aus, so daß der SAFE-Eingang 80 der Kontrolleinheit 40 auf HIGH liegt. Solange das erste elektrische Gerät 1 an das zweite elektrische Gerät 5 in der beschriebenen Weise angeschlossen ist, sind das erste und das zweite Bezugspotential 15 und 25 identisch, da sie im zweiten elektrischen Gerät 5 mit einem gemeinsamen, dem dritten Bezugspotential 150 verbunden sind.

Bei Auftrennen des Verbindungskabels 35 z. B. bei Diebstahl werden auch die erste und die zweite Leitung 10 und 20 durchgetrennt, so daß der erste und der zweite Pol 95 und 100 nicht mehr miteinander verbunden sind. Auf diese Weise stellt sich zwischen dem ersten Pol 95 und dem zweiten Pol 100 eine Spannungsdifferenz ein, die durch die erste und die zweite Diode 70 und 75 begrenzt ist. Da bei Auftrennen des Verbindungskabels 35 auch die Versorgungsspannungsleitung 30 durchgetrennt wird, ist das erste elektrische Gerät 1 von der Spannungsversorgung abgeschnitten. Daher ergibt sich die Spannungsdifferenz zwischen dem ersten und dem zweiten Pol 95 und 100 durch die im ersten elektrischen Gerät 1 verbleibende Restladung, die gemäß der Figur als Ladung des ersten Kondensators 50 zu verstehen ist. Durch die Restladung des ersten Kondensators 50 wird also die Spannungsdifferenz zwischen dem ersten Pol 95 und dem zweiten Pol 100 eingestellt und die erste und die zweite Diode 70 und 75 in Durchlaßrichtung geschaltet. Durch den Spannungsabfall an der ersten und der zweiten Diode 70 und 75 wird die Steuerspannung am Steuereingang 85 des npn-Bipolartransistors 45 so weit erhöht, daß der npn-Bipolartransistor 45 geschlossen wird und der SAFE-Eingang 80 der Kontrolleinheit 40 auf LOW geht. Die Restladung des ersten Kondensators 50 übernimmt nach Auftrennung der Versorgungsspannungsleitung 30 auch die Energieversorgung der Kontrolleinheit 40. Sobald der npn-Bipolartransistor 45 durchschaltet, wird der Timer 115 von der Kontrolleinheit gestartet. Außerdem wird der mit dem Spannungsmesser 160 gemessene Spannungswert am Meßwiderstand 130 in der Kontrolleinheit 40 mit einem vorgegebenen Spannungswert verglichen. Wenn nach Ablauf einer vorgegebenen Zeit durch den Timer 115 die gemessene Spannung unter den vorgegebenen Wert abgesunken ist, so wird in der Kontrolleinheit 40 ein Sicherungsvorgang aktiviert, der beispielsweise durch Setzen eines sogenannten Diebstahlbits das elektronische Schloß 110 aktiviert. Bei Wiederanschluß an eine Spannungsversorgung kann das elektronische Schloß 110 nur durch Eingabe eines Codewortes am Tastenfeld 200 des Bedienteils 120 durch Rücksetzen des Diebstahlbits entriegelt werden. Das erste elektrische Gerät 1 ist dann wieder betriebsbereit und das erste und das zweite Bezugspotential 15 und 25 sind wieder identisch, so daß der npn-Bipolartransistor 45 wieder geöffnet ist und der SAFE-Eingang 80 der Kontrolleinheit 40 auf HIGH liegt.

Da die Spannungsversorgung der Kontrolleinheit 40 nach Auftrennen des Verbindungskabels 35 durch die Ladung des ersten Kondensators 50 erfolgt, muß der dritte Kondensator 125 schneller als der erste Kondensator 50 entladen sein, damit der Sicherungsvorgang überhaupt gestartet werden kann. Für eine entsprechend schnelle Entladung des dritten Kondensators 125 sorgt der Meßwiderstand 130, der daher dementsprechend niederohmig zu dimensionieren ist. Die durch den Timer 115 vorgebbare Zeit bis zur Aktivierung des Sicherungsvorgangs dient dazu, bei kurzzeitigen Spannungsunterbrechungen, die nicht auf einer Auftrennung des Verbindungskabels 35 beruhen und damit nicht auf Diebstahl zurückzuführen sind, eine ungewollte Aktivierung des Diebstahlschutzes zu verhindern. Dasselbe gilt auch für den Vergleich des gemessenen Spannungswertes mit einem vorgegebenen Wert in Kontrolleinheit 40, da kurzzeitige Spannungsunterbrechungen, die nicht auf eine Auftrennung des Verbindungskabels 35 zurückzuführen sind, auch keinen allzu großen Versorgungsspannungsabfall zur Folge haben und nicht zur Aktivierung des Diebstahlschutzes führen sollen. Für ein entsprechend rasches Absinken der Restladung auf dem dritten Kondensator 125 bei Auftrennen des Verbindungskabels 35 sorgt dann der Meßwiderstand 130, so daß ein Diebstahl möglichst schnell detektiert wird und dem Dieb keine Gelegenheit gelassen wird, eine Ersatzspannungsquelle anzuschließen. Die mittels des Timers 115 vorgebbare Zeit muß dabei auf die durch die Kapazität des dritten Kondensators 125 und den Meßwiderstand 130 gebildete Zeitkonstante für das Absinken der Versorgungsspannung abgestimmt sein. Durch den zweiten Kondensator 90 wird verhindert, daß der npn-Bipolartransistor 45 bei kurzzeitigen Spannnungsunterbrechungen, induktiven Störungen oder Pegelspitzen auf den beispielsweise bis zu 6 m langen Leitungen 10, 20, 30 im Verbindungskabel 35 durchschaltet, um den Sicherungsvorgang in der Kontrolleinheit 40 zu aktivieren. Dazu muß die Kapazität des zweiten Kondensators 90 genügend groß sein. Andererseits muß sie kleiner sein, als die Kapazität des ersten Kondensators 50, damit der Spannungssprung zwischen dem ersten Pol 95 und dem zweiten Pol 100 des ersten elektrischen Gerätes 1 am Steuereingang 85 des npn-Bipolartransistors 45 überhaupt wirksam werden kann. Bei einer Kapazität von 47 nF des zweiten Kondensators 90 reicht eine Kapazität in der Größenordnung von 220 µF des ersten Kondensators 50 zum Durchschalten des npn-Bipolartransistors 45 und zur Aktivierung des Sicherungsvorgangs bei Auftrennen des Verbindungskabels 35 aus.

Bei nicht durchgetrenntem Verbindungskabel 35 sorgen die erste, die zweite und die dritte Diode 70, 75 und 190 dafür, daß durch Spannungsunterbrechungen bedingte Spannungsdifferenzen zwischen dem ersten und dem zweiten Pol 95 und 100 des ersten elektrischen Gerätes 1 begrenzt bleiben und somit keine Schaltkreise beschädigt werden.

Der Meßwiderstand 130 kann in einem weiteren Ausführungsbeispiel schaltbar ausgeführt sein, so daß er dem dritten Kondensator 125 nur nach Entfernen der Versorgungsspannung parallel geschaltet wird, um unnötigen Stromverlust zu vermeiden. Die Zuschaltung des Widerstandes erfolgt dann direkt nach dem Schaltvorgang des Sensors und wird von der Kontrolleinheit 40 durch Ansteuerung beispielsweise eines entsprechenden Relais bewirkt. Weiterhin kann als Meßgröße statt der Versorgungsspannung selbst auch eine daraus abgeleitete Größe Verwendung finden. Dazu kann beispielsweise die Versorgungsspannung durch einen weiteren Spannungsteiler geteilt oder eine zur Versorgungsspannung proportionale Stromstärke oder dergleichen verwendet werden. Am dritten Kondensator 125 kann somit auch die durch den weiteren Spannungsteiler geteilte Versorgungsspannung anliegen.

## Patentansprüche

1. Elektrisches Gerät (1), insbesondere CD-Wechsler, das als erstes elektrisches Gerät(1) zum Anschluss über ein Verbindungskabel (35) an ein zweites elektrisches Gerät (5), insbesondere ein Autoradio, vorgesehen ist, wobei der Anschluss einen ersten Pol (95) für ein erstes Bezugspotential (15) und einen zweiten Pol (100) für ein zweites Bezugspotential (25) aufweist und wobei im zweiten elektrisches Gerät (5) das erste Bezugspotential (15) und das zweite Bezugspotential (25) mit einander verbunden werden, wobei der Anschluss einen dritten Pol (55) aufweist, an dem eine vom zweiten elektrischen Gerät (5) über das Verbindungskabel (35) zugeführte Versorgungsspannung anliegt, und wobei im ersten elektrischen Gerät (1) eine Kontrolleinheit (40) zur Steuerung des ersten elektrischen Geräts (1) vorgesehen ist, **dadurch gekennzeichnet, dass** sich beim Auftrennen der Verbindung zwischen dem ersten und dem zweiten Pol (95, 100) durch eine im ersten Gerät (1) verbleibende Restladung eine Spannungsdifferenz zwischen diesen beiden Polen (95, 100) einstellt, durch die sich in der Kontrolleinheit (40) ein Sicherungsvorgang auslöst.

2. Elektrisches Gerät (1) nach Anspruch 1, **dadurch gekennzeichnet, dass** sich die Spannungsdifferenz zwischen dem ersten und dem zweiten Pol (95, 100) durch die im ersten elektrischen Gerät (1) als Ladung eines ersten Kondensators (50) verbleibende Restladung einstellt.

3. Elektrisches Gerät (1) nach Anspruch 1 oder 2, **dadurch gekennzeichnet, daß** mindestens ein erster Kondensator (50) einerseits mit einem von der Versorgungsspannung abgeleiteten Betriebsspannungspotential (105) und andererseits mit dem ersten Bezugspotential (15) verbunden ist, daß ein Betriebsspannungspotential (105) des ersten elektrischen Geräts (1) über einen Spannungsteiler (60, 65) mit dem zweiten Bezugspotential (25) verbunden ist, daß das zweite Bezugspotential (25) über mindestens eine Diode (70, 75) in Flußrichtung mit dem ersten Bezugspotential (15) verbunden ist, daß der Spannungsteiler (60, 65) die Steuerspannung eines vorzugsweise als Schalter ausgebildeten Sensors (45) in Abhängigkeit von der Betriebsspannung einstellt und daß der Sensor (45) zwischen einem Eingang (80) der Kontrolleinheit (40) für die Auslösung des Sicherungsvorgangs und dem ersten Bezugspotential (15) angeordnet ist.

4. Elektrisches Gerät (1) nach Anspruch 1, 2 oder 3, **dadurch gekennzeichnet, daß** zwischen dem Steuereingang (85) des Sensors (45) und dem ersten Bezugspotential (15) ein zweiter Kondensator (90) geschaltet ist, dessen Kapazität kleiner als die Kapazität des ersten Kondensators (50) ist.

5. Elektrisches Gerät (1) nach einem der vorherigen Ansprüche, **dadurch gekennzeichnet, daß** der Kontrolleinheit (40) die Betriebsspannung zugeführt ist und däß bei Auftrennen der Verbindung zwischen dem ersten und dem zweiten Pol (95, 100) die Spannungsversorgung der Kontrolleinheit (40) durch die Restladung des ersten Kondensators (50) erfolgt.

6. Elektrisches Gerät (1) nach einem der vorherigen Ansprüche, **dadurch gekennzeichnet, daß** die beim Auftrennen der Verbindung zwischen dem ersten und dem zweiten Pol (95, 100) entstehende Spannungsdifferenz zwischen diesen beiden Polen (95, 100) die Steuerspannung des Sensors (45) so verändert, daß ein Schaltvorgang stattfindet und den Sicherungsvorgang in der Kontrolleinheit (40) auslöst.

7. Elektrisches Gerät (1) nach einem der vorherigen Ansprüche, **dadurch gekennzeichnet, daß** das erste elektrische Gerät (1) ein mit der Kontrolleinheit (40) zusammenwirkendes elektronisches Schloß (110) aufweist und daß beim Sicherungsvorgang die Aktivierung des elektronisches Schlosses (110) erfolgt.

8. Elektrisches Gerät (1) nach einem der vorherigen Ansprüche, **dadurch gekennzeichnet, daß** eine Aktivierung des Sicherungsvorgangs nach einer durch einen mit der Kontrolleinheit (40) zusammenwirkenden Timer (115) vorgebbaren Verzögerungszeit stattfindet.

9. Elektrisches Gerät (1) nach Anspruch 7, **dadurch gekennzeichnet, daß** das elektronische Schloß (110) durch Eingabe eines Codewortes an einem mit der Kontrolleinheit (40) verbundenen Bedienteil (120) des ersten elektrischen Gerätes (1) entriegelbar ist.

10. Elektrisches Gerät (1) nach einem der vorherigen Ansprüche, **dadurch gekennzeichnet, daß** eine Messung der Versorgungsspannung oder einer daraus abgeleiteten Größe im ersten elektrischen Gerät (1) erfolgt, daß eine Zuführung des Meßergebnisses zur Kontrolleinheit (40) stattfindet und daß zur Aktivierung des Sicherungsvorgangs in der Kontrolleinheit (40) zusätzlich die gemessene Versorgungsspannung oder die daraus abgeleitete Größe im ersten elektrischen Gerät (1) unter einen vorgegebenen Wert absinken muß.

11. Elektrisches Gerät (1) nach einem der vorherigen Ansprüche, **dadurch gekennzeichnet, daß** die Versorgungsspannung zumindest teilweise an mindestens einem dritten Kondensator (125) anliegt, dem ein Widerstand (130) parallel schaltbar ist, zur schnellen Entladung des dritten Kondensators (125) beim Entfernen der Versorgungsspannung.

12. Elektrisches Gerät (1) nach einem der vorherigen Ansprüche, **dadurch gekennzeichnet, daß** das erste Bezugspotential (15) für die digitale Signalverarbeitung und das zweite Bezugspotential (25) für die analoge Signalverarbeitung vorgesehen sind.

## Claims

1. Electrical appliance (1), particularly a CD changer, which is provided as a first electrical appliance (1) for connection by means of a connecting cable (35) to a second electrical appliance (5), particularly a car radio, where the connection has a first pole (95) for a first reference-earth potential (15) and a second pole (100) for a second reference-earth potential (25) and where the first reference-earth potential (15) and the second reference-earth potential (25) are connected to one another in the second electrical appliance (5), where the connection has a third pole (55) to which a supply voltage supplied by the second electrical appliance (5) via the connecting cable (35) is applied, and where the first electrical appliance (1) contains a control unit (40) for controlling the first electrical appliance (1), **characterized in that** breaking the connection between the first and the second pole (95, 100) involves a residual charge which remains in the first appliance (1) establishing a voltage difference between these two poles (95, 100) which triggers a protection operation in the control unit (40).

2. Electrical appliance (1) according to Claim 1, **characterized in that** the voltage difference between the first and the second pole (95, 100) is established as a charge on a first capacitor (50) by the residual charge which remains in the first electrical appliance (1).

3. Electrical appliance (1) according to Claim 1 or 2, **characterized in that** at least one first capacitor (50) is connected firstly to an operating voltage potential (105) derived from the supply voltage and secondly to the first reference-earth potential (15), **in that** an operating voltage potential (105) in the first electrical appliance (1) is connected to the second reference-earth potential (25) via a voltage divider (60, 65), **in that** the second reference-earth potential (25) is connected to the first reference-earth potential (15) via at least one diode (70, 75) in the forward direction, **in that** the voltage divider (60, 65) sets the control voltage for a sensor (45), which is preferably in the form of a switch, on the basis of the operating voltage, and **in that** the sensor (45) is arranged between an input (80) of the control unit (40) for triggering the protection operation and the first reference-earth potential (15).

4. Electrical appliance (1) according to Claim 1, 2 or 3, **characterized in that** the control input (85) of the sensor (45) and the first reference-earth potential (15) have a second capacitor (90) connected in between them whose capacitance is lower than the capacitance of the first capacitor (50).

5. Electrical appliance (1) according to one of the preceding claims, **characterized in that** the control unit (40) has the operating voltage supplied to it and **in that** breaking the connection between the first and the second pole (95, 100) involves the voltage supply in the control unit (40) being provided by the residual charge on the first capacitor (50).

6. Electrical appliance (1) according to one of the preceding claims, **characterized in that** the voltage difference arising between the first and the second pole (95, 100) when breaking the connection between these two poles (95, 100) alters the control voltage for the sensor (45) such that a switching operation takes place and triggers the protection operation in the control unit (40).

7. Electrical appliance (1) according to one of the preceding claims, **characterized in that** the first electrical appliance (1) has an electronic lock (110) interacting with the control unit (40) and **in that** the protection operation involves the electronic lock (110) being activated.

8. Electrical appliance (1) according to one of the preceding claims, **characterized in that** the protection operation is activated after a delay time which can be prescribed by a timer (115) which interacts with the control unit (40).

9. Electrical appliance (1) according to Claim 7, **characterized in that** the electronic lock (110) can be unlocked by inputting a code word on a control section (120), connected to the control unit (40), in the first electrical appliance (1).

10. Electrical appliance (1) according to one of the preceding claims, **characterized in that** the supply voltage or a variable derived therefrom in the first electrical appliance (1) is measured, **in that** the measurement result is supplied to the control unit (40), and **in that**, to activate the protection operation in the control unit (40), the measured supply voltage or the variable derived therefrom in the first electrical appliance (1) additionally needs to drop below a prescribed value.

11. Electrical appliance (1) according to one of the preceding claims, **characterized in that** at least some of the supply voltage is applied to at least one third capacitor (125), which can have a resistor (130) connected in parallel with it, for the purpose of rapidly discharging the third capacitor (125) when the supply voltage is removed.

12. Electrical appliance (1) according to one of the preceding claims, **characterized in that** the first reference-earth potential (15) is provided for the digital signal processing and the second reference-earth potential (25) is provided for the analogue signal processing.

## Revendications

1. Appareil électrique (1), en particulier changeur de cédérom, qui est prévu comme premier appareil électrique (1) destiné à être raccordé, par l'intermédiaire d'un câble de liaison (35) à un deuxième appareil électrique (5), en particulier, à un autoradio, le raccordement présentant un premier pôle (95) pour un premier potentiel de référence (15) et un deuxième pôle (100) pour un deuxième potentiel de référence (25) et le premier potentiel de référence (15) et le deuxième potentiel de référence (25) étant reliés l'un à l'autre dans le deuxième appareil électrique (5), le raccordement présentant un troisième pôle (55) auquel est présente une tension d'alimentation transmise en provenance du deuxième appareil électrique (5) par l'intermédiaire du câble de liaison (35), et une unité de contrôle (40) étant prévue dans le premier appareil électrique (1) pour la commande du premier appareil électrique (1),
**caractérisé en ce qu'**
en cas de coupure de la liaison entre les premier et deuxième pôles (95, 100), une tension résiduelle restant dans le premier appareil électrique (1) établit entre ces deux pôles (95, 100) une différence de tension par laquelle un processus de mise en sécurité est déclenché dans l'unité de contrôle (40).

2. Appareil électrique (1) selon la revendication 1,
**caractérisé en ce que**
la différence de tension entre les premier et deuxièmes pôles (95, 100) s'établit par la tension résiduelle subsistant dans le premier appareil électrique (1) sous la forme de la charge d'un premier condensateur (30).

3. Appareil électrique (1) selon la revendication 1 ou 2,
**caractérisé en ce qu'**
au moins un premier condensateur (50) est relié, d'une part à un potentiel de tension de service (105) dérivé de la tension d'alimentation et, d'autre part au premier potentiel de référence (15), un potentiel de tension de service (105) du premier appareil électrique (1) est relié au deuxième potentiel de référence (25) à travers un diviseur de tension (60, 65), le deuxième potentiel de référence (25) est relié au premier potentiel de référence (15) dans le sens du passage du courant au moyen d'au moins une diode (70, 75), le diviseur de tension (60, 65) établit la tension de commande d'un capteur (45) constitué de préférence par un commutateur, en fonction de la tension de service, et le capteur (45) est disposé entre une entrée (80) de l'unité de contrôle (40) pour le déclenchement du processus de mise en sécurité et le premier potentiel de référence (15).

4. Appareil électrique (1) selon la revendication 1, 2 ou 3,
**caractérisé en ce qu'**
entre l'entrée de commande (85) du capteur (45) et le premier potentiel de référence (15), est connecté un deuxième condensateur (90) dont la capacité est plus petite que la capacité du premier condensateur (50).

5. Appareil électrique (1) selon une des revendications précédentes,
**caractérisé en ce que**
la tension de service est transmise à l'unité de contrôle (40) et **en ce que**, en cas de coupure de la liaison entre les premier et deuxième pôles (95, 100), l'alimentation en tension de l'unité de contrôle (40) s'effectue par la charge résiduelle du premier condensateur (50).

6. Appareil électrique (1) selon une des revendications précédentes,
**caractérisé en ce que**
la différence de tension qui, en cas de coupure de la liaison entre les premier et deuxième pôles (95, 100), apparaît entre ces deux pôles (95, 100) modifie la tension de commande du capteur (45) de telle sorte qu'un processus de commutation a lieu et déclenche le processus de mise en sécurité dans l'unité de contrôle (40).

7. Appareil électrique (1) selon une des revendications précédentes,
**caractérisé en ce que**
le premier appareil électrique (1) présente une serrure électronique (110) qui coopère avec l'unité de contrôle (40) et l'activation de la serrure électronique (110) se produit lors du processus de mise en sécurité.

8. Appareil électrique (1) selon une des revendications précédentes,
**caractérisé en ce qu'**
une activation du processus de mise en sécurité se produit après un temps de temporisation qui peut être prédéterminé par un minuteur (115) coopérant avec l'unité de contrôle (40).

9. Appareil électrique (1) selon la revendication 7,
**caractérisé en ce que**
la serrure électronique (110) peut être déverrouillée par l'entrée d'un mot de code sur une partie de commande (120) du premier appareil électrique (1) qui est reliée à l'unité de contrôle (40).

10. Appareil électrique (1) selon une des revendications précédentes,
**caractérisé en ce qu'**
une mesure de la tension d'alimentation ou d'une grandeur qui en est dérivée se produit dans le premier appareil électrique (1), qu'il se produit une transmission du résultat de la mesure à l'unité de contrôle (40) et que, pour l'activation du processus de mise en sécurité dans l'unité de contrôle (40), il faut qu'en supplément, la tension d'alimentation mesurée ou la grandeur qui en est dérivée dans le premier appareil électrique (1) tombe au-dessous d'une valeur prédéterminée.

11. Appareil électrique (1) selon une des revendications précédentes,
**caractérisé en ce que**
la tension d'alimentation est présente au moins en partie sur au moins un troisième condensateur (125) en parallèle avec lequel une résistance (130) peut être connectée, pour la décharge rapide du troisième condensateur (125) lors de la disparition de la tension d'alimentation.

12. Appareil électrique (1) selon une des revendications précédentes,
**caractérisé en ce que**
le premier potentiel de référence (15) est prévu pour le traitement numérique des signaux et le deuxième potentiel de référence (25) pour le traitement analogique des signaux.
